Europäisches Patentamt

European Patent Office

Office européen des brevets

(19)

(11) Publication number: **0 108 514**
**B1**

(12) **EUROPEAN PATENT SPECIFICATION**

(45) Date of publication of patent specification: **22.03.89**

(51) Int. Cl.⁴: **G 01 B 11/27, G 03 B 41/00**

(21) Application number: **83306126.0**

(22) Date of filing: **10.10.83**

(54) Alignment aid.

(30) Priority: **12.10.82 GB 8229119**

(43) Date of publication of application:
**16.05.84 Bulletin 84/20**

(45) Publication of the grant of the patent:
**22.03.89 Bulletin 89/12**

(84) Designated Contracting States:
**DE FR GB IT NL SE**

(56) References cited:
**US-A-4 272 191**

(73) Proprietor: **The Secretary of State for Trade and Industry in Her Britannic Majesty's Government of the United Kingdom of Great Britain and Northern Ireland 1 Victoria Street**
**London SW1H OET (GB)**

(72) Inventor: **Reid, Graeme Thomas**
**93 High Street**
**Stewarton Ayreshire Scotland (GB)**

(74) Representative: **Wildman, David Brian et al Procurement Executive Ministry of Defence Patents 1A(4), Room 2014 Empress State Building Lillie Road**
**London SW6 1TR (GB)**

EP 0 108 514 B1

## Description

This invention relates to an alignment aid for facilitating the accurate superposition of two or more transparencies.

It is necessary to superimpose photographic transparencies accurately in a number of optical processes. Optical metrology is concerned with extremely accurate measurement. In one metrological method commonly known as Moire topography, a grating of equi-spaced parallel lines is projected on to the object to be measured and photographs are taken of the grating projected on to the object and also on to a flat reference screen. When the two photographic transparencies are superimposed the gratings combine to give Moire fringes in the form of contour lines representing the relief of the object. As the position of the contour lines depends upon the phase of the two observed gratings it is necessary to be able to superimpose the transparencies accurately in order to give precise values to each of the contour lines produced.

Moire fringes are also used in a variation of the above described technique to measure the deformation of a subject material under stress. A grating is projected onto the object under test and photographic transparencies are produced of the object when relaxed and when stressed. When the two transparencies are superimposed Moire fringes are produced which can be recorded and interpreted to give information about the surface deformation of the object.

In both of the above described metrological techniques it is imperative that the transparencies shall be accurately superimposed as regards both rotational and translational displacements. To help achieve this it is common to include in the information recorded on the photographic transparency one or more alignment aids in the form of crosswires or segmented circles. Often the alignment achievable with the unaided human eye is not sufficiently precise and the alignment aids must each be viewed through a microscope in order to detect the position of best alignment. Since up to four alignment aids may be present on each transparency and each one must repeatedly be viewed microscopically, the accurate superposition of the transparencies is a skilled and lengthy process.

There thus exists a need for an alignment aid which is capable of facilitating simple, quick and accurate alignment between two superimposed transparencies in both rotation and translational senses, ie so that no degree of freedom remains for misalignment. Such alignment is herein termed 'absolute alignment', and the present invention seeks to satisfy this need.

The invention depends upon use of a Moire fringe effect between superimposed patterns. Moire fringes effects are primarily being utilised for Moire topography as described hereinbefore, and in devices for the accurate measurement of displacement. The Applicant is also aware of two prior proposals from very different arts in which the effect is used as an alignment aid.

In one case, as an aid to the angular alignment of inclined blast holes, closely spaced parallel lines are engraved on a pair of parallel acrylic plates, one fixed, the other freely pivoted under gravity. As light passes through, an interference pattern of broad arrows is formed when the two plates are out of angular alignment. This effect is utilised to align the drill accurately at the same angle for successive bores.

In the other case, as disclosed in UK Patent No. 1174781, an alignment aid for the positioning of colour negatives so as to obtain accurate registration thereof, comprises a pattern of concentric rings on each member to be aligned. Any translational displacement between the members when superimposed is indicated by a Moire fringe pattern set up between the two sets of markings.

These two prior art systems enable greatly increased accuracy to be achieved with direct visual observation, ie without the use of magnification devices. However, both suffer from the shortcoming that neither is capable of facilitating absolute alignment. In the one case, parallel lines cannot indicate a translational displacement, and in the other case, the pattern of circles cannot indicate an angular displacement.

As noted hereinbefore, accurate alignment of transparencies requires absolute alignment, and the presently employed method involving up to four alignment aids is time consuming. It would be possible to envisage a system based on the disclosure of UK Patent No. 1174781 having eg a pattern of circles in opposite corners of a transparency. A similar scheme with two patterns of parallel lines would not provide information about translational alignment. In any event, although a Moire fringe system would in many instances avoid the necessity for magnification by a microscope, the need for two or more alignment aids displaced one from another renders the alignment process tedious, because of the need to check repeatedly that adjustment of one alignment aid has not displaced another.

The present invention provides an article carrying an alignment aid based on the use of Moire interference fringes which avoids this difficulty, to the extent that even for highly accurate work requiring the use of a microscope, the alignment process is rendered very simple and straightforward.

Thus, according to one aspect of the invention, there is provided an article having an alignment aid thereon characterised by comprising a single region of markings in the form of closely spaced lines, the arrangement of lines within the single region being such that on superimposition of such an alignment aid on a transparency over such an alignment on another article, Moire fringes are formed by interaction of the superimposed markings of the respective single regions, unless the alignment aids are aligned in both translation and angular sense, the closely spaced lines being in the form of:

a. at least one spiral

b. a zone of straight parallel lines and a zone wherein the closely spaced lines are in the form of concentric circles, or

c. concentric ellipses having a common major axis.

Preferably, adjacent lines of the markings are equispaced one from another. This will help to produce a regular pattern of Moire fringes when superimposed alignment aids are misaligned, making the fringes easier to interpret.

When the alignment aid comprises a region of markings comprising a spiral or, at least two concentric spirals, two identical regions of such spiral markings superimposed one upon the other in absolute alignment will retain the appearance of a spiral. If, however, the two spirals are laterally offset one from the other, the misalignment will cause the regions of markings to produce Moire fringes. The regions will not retain the appearance of the original spirals but dark fringes extending radially from the centre of the spirals, and easily observable with the naked eye, will be present. The first Moire fringe will begin to appear when the alignment aids are laterally offset one from the other (ie translationally misaligned) by one half of the spacing between adjacent lines of the spiral.

If the two spiral markings are translationally in alignment but rotationally misaligned then one or more circular Moire fringes appear, concentric about the centre of the spirals. The misalignment necessary to produce the first Moire fringe will be dependent, for a single spiral, on the line density (the pitch of the spiral). The sensitivity may be increased by employing two or more nested concentric spirals (ie an overall spiral region with several 'starts').

When the alignment aid comprises a single region of markings in the form of a zone consisting of a plurality of concentric circles, surrounded by a zone consisting of a plurality of straight lines parallel one with another, two such alignment aids which are superimposed yet translationally misaligned cause radially extending fringes to appear on the zone of concentric circles. As with the spiral markings previously described, the first Moire fringe will begin to appear when the alignment aids are laterally offset by one half of the spacing between adjacent circles. No fringes will be observed in the zone of parallel lines because translational misalignment between two such patterns of markings without rotation will still leave the lines parallel one with the other.

If two such alignment aids are translationally aligned and yet rotationally misaligned no fringes will be observed in the zone of concentric circles. However one or more dark interference fringes will appear on the zone of parallel lines. The spacing S, between adjacent fringes on the zone of parallel lines is given by the equation:

$$S = \frac{P}{2 \sin (A/2)} \qquad (1)$$

where

p is the spacing between adjacent parallel lines, and

A is the rotational angle through which the two alignment aids are misaligned.

The combination of the zone of concentric circles to detect lateral misalignment and the zone of parallel straight lines to detect angular misalignment ensures that Moire fringes are always observable except when the two or more alignment aids are in absolute alignment one with another, ie both rotationally and translationally aligned.

When the alignment aid comprises a region of markings in the form of a plurality of concentric ellipses having a common major axis, misalignment between two or more regions of elliptical markings produces one or more Moire interferences fringes extending radially outwardly from each of the two foci common to each of the concentric ellipses. These fringes will only disappear and the markings resume a uniform appearance when the alignment aids are in absolute alignment, ie with the ellipses superimposed exactly one upon another without angular or translational misalignment.

In order not to interfere with the information recorded on the transparency, a rectangular transparency according to the present invention will normally have an alignment aid as described above positioned in one of its four corners, or adjacent an edge thereof.

According to another aspect of the invention, a process for reproducing an image of an original representation characterised in that it comprises the steps of

applying to the original representation an alignment aid so as to create an article in accordance with any one preceding claim,

preparing a plurality of transparencies each representing a component of the original representation and each including a reproduction of the alignment aid,

and reproducing an image of each transparency in turn, successive images being superimposed in accurate alignment by use of the reproductions of the alignment aid.

The original representation may be a colour photograph, each transparency representing a monochrome component thereof, and each transparency being subjected to colour correction prior to reproduction of an image thereof.

Alternatively, the original representation may be in colour, each transparency representing a monochrome component thereof, an image of each transparency including the alignment aid being reproduced on a respective printing plate, and a monochrome image of each

transparency being printed from its respective plate, successive images being superimposed in accurate alignment by use of reproductions of the alignment aid.

According to a still further aspect of the invention there is provided a process for the production of a double sided printed circuit board, comprising the steps of

preparing two master transparencies each representing the conductive pattern to be applied to one side of the board, characterised by including on each master transparency on alignment aid so as to create an article in accordance with the invention, the alignment aid being so positioned as to fall outside the boundary of the board when aligned therewith,

superimposing and aligning the two master transparencies on opposite sides of the board by use of superimposed alignment aids, and

transferring the pattern of the two master transparencies to the opposite sides of the board.

The invention will now be more particularly described, by way of example only, with reference to the accompanying drawings, in which

Figure 1 is a view of a part of a transparency in accordance with the invention carrying an alignment aid in the form of a pattern of spirals,

Figure 2 is a view of the alignment aid of Figure 1 superimposed upon another similar aid but angularly misaligned with respect thereto,

Figure 3 is a view of the alignment aid of Figure 1 superimposed upon another similar aid, but translationally misaligned with respect thereto,

Figure 4 is a view of part of a transparency carrying another form of alignment aid according to the present invention,

Figure 5 is a view of the alignment aid of Figure 4 shown when superimposed upon an indentical alignment aid and translationally misaligned with respect thereto,

Figure 6 is a view of the alignment aid of Figure 4 shown when superimposed upon an identical alignment aid and angularly misaligned with respect thereof, and

Figure 7 is a view of the alignment aid of Figure 4 shown when superimposed upon an identical alignment aid and misaligned both translationally and angularly with respect thereto.

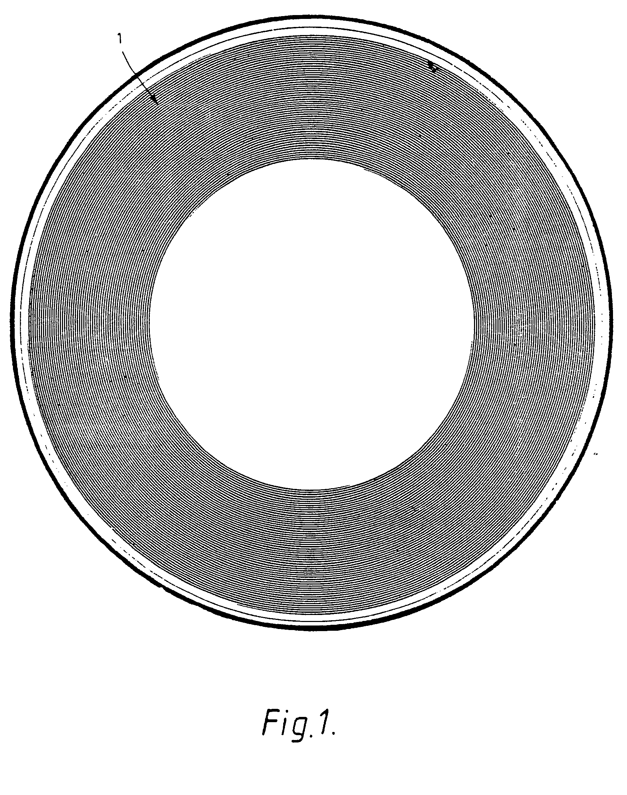

The alignment aid shown in Figure 1 comprises a pattern of five nested spirals, ie a five-start spiral pattern. The maximum diameter of the pattern is not greater than about 1 cm, and the line density is about 100 lines/mm. With such an arrangement, alignment sensitivity of the order of $5 \times 10^{-6}$m is easily achieved.

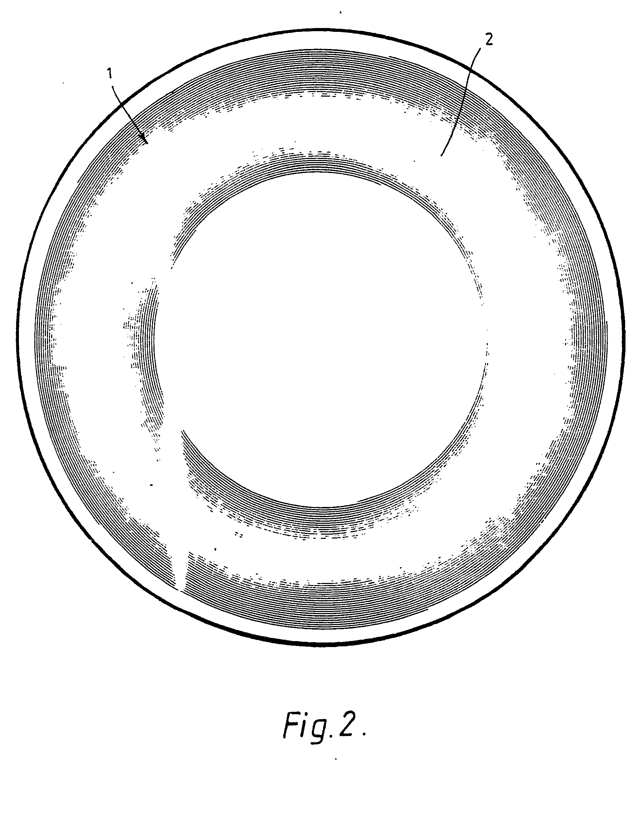

Figure 2 shows the effect of angular misalignment between two similar superimposed alignment aids. As seen therein, a circular Moire fringe 2 is produced in the spiral pattern.

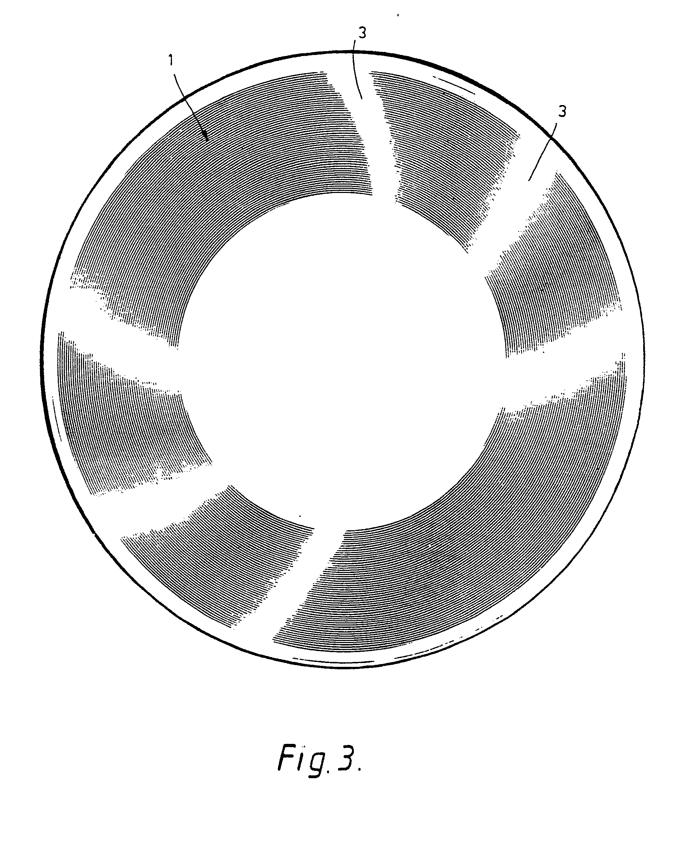

Figure 3 shows the effect of a purely translational displacement. In this case a pattern of radially disposed Moire fringes 3 is created.

The alignment aid shown in Figures 1—3 occupies only very small proportion of the surface of the transparency, and the complete alignment aid occupies only a single small region adjacent the perimeter of the transparency (eg in a corner or near an edge).

Accurate alignment of even a large transparency is made simple, by direct visual observation of a single small region. Normally microscopic observation is unnecessary, although a microscope can be used if exceptional accuracy is required. The whole procedure is much simplified as compared to any prior proposal, particularly in that the need for repeated observation of several widely spaced alignment aids is avoided.

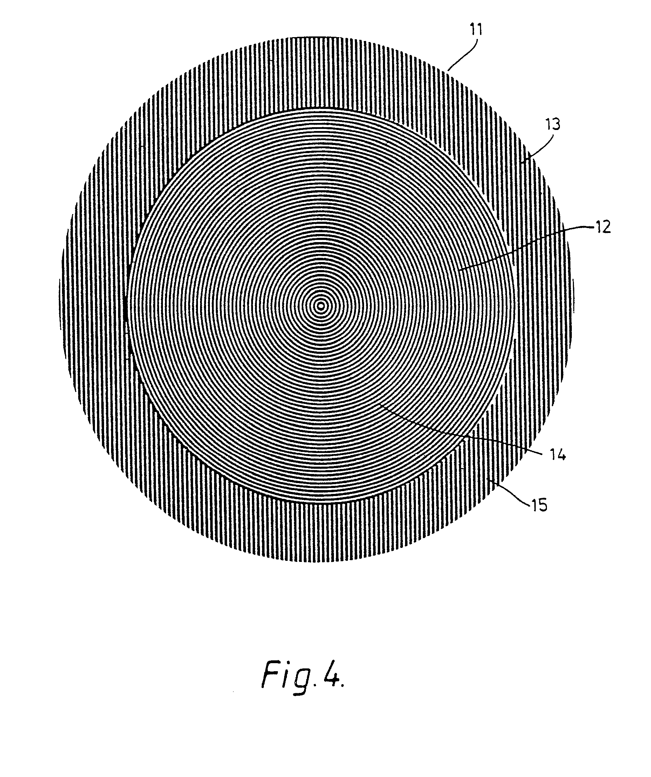

The boundary of the alignment aid of Figure 4 is generally circular as shown at 11 (although no special importance attaches to this particular shape). It comprises an inner zone or portion 12 and an outer zone or portion 13. The inner portion 12 comprises markings 14 in the form of a plurality of concentric circles, equispaced one from another. The outer portion 13 comprises a different set of markings 15 in the form of a plurality of straight lines parallel one with another.

The alignment aid 11 is present in one corner of each of two transparencies which require to be accurately superimposed one upon another. When the transparencies are in absolute alignment one upon another the markings of the alignment aids are exactly superimposed and the alignment aid 11 retains the appearance of the markings 14 and 15 as shown in Figure 4.

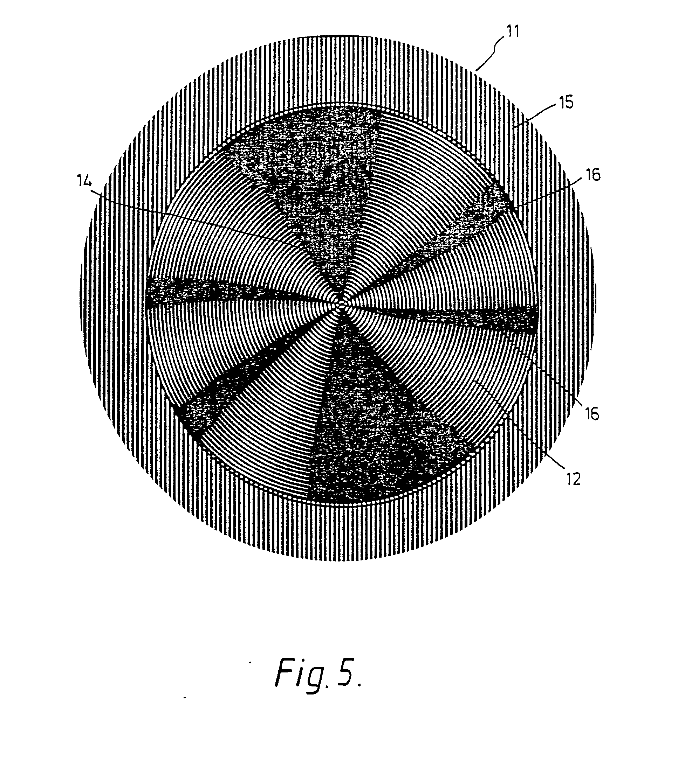

Figure 5 shows the effect of a small translational misalignment between two superimposed alignment aids of the kind shown in Figure 4. The translational misalignment has no affect upon the appearance of the straight line markings 15 but causes dark fringes 16 to appear in the portion 12 containing the concentric circles 14. As stated previously the first fringe is observable once the alignment aids are misaligned by one half of the spacing between adjacent circles. Line densities of up to 200 per mm may be recorded on a photographic transparency without resorting to the use of specialised lenses. This means that the first Moire fringe is observed when the alignment aids 11 are misaligned by only 2.5 microngs. This accuracy is furthermore obtained without the need for magnification of the alignment aid for the fringes 16 are clearly visible to the naked eye.

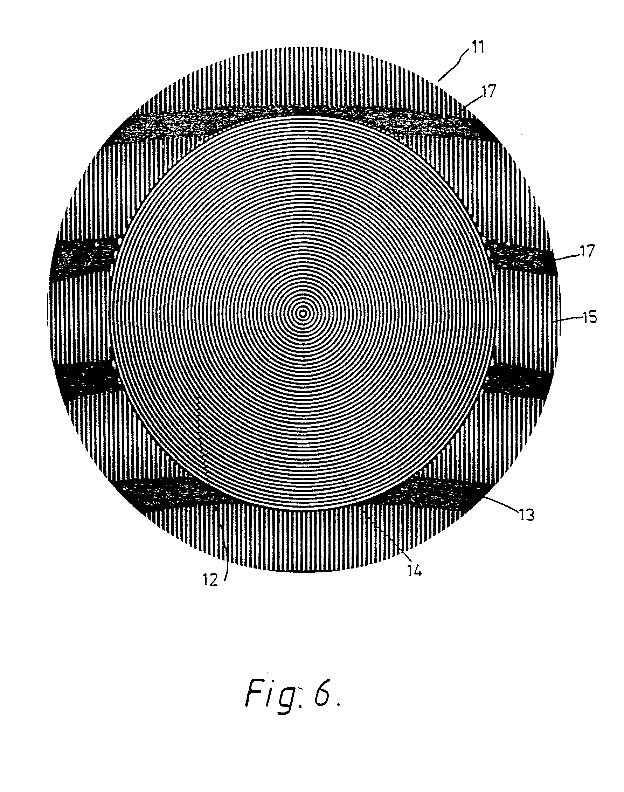

Figure 6 shows the effect of the superposition of the two alignment aids 11 in translational alignment but with one alignment aid rotated relative to the other by a small amount. The angular misalignment has no apparent effect on the portion 12 containing the circular markings 14 which retain their original appearance as in Figure 4. However dark Moire interference fringes 17 are observed in the portion 13 containing the grid of parallel straight lines 15. Assuming once again a line density of 200 per mm, and also assuming the alignment aid 11 to have a diameter of about 1 cm in the corner of a transparency, equation (1) predicts that an angular misalignment of 0.03° can be detected by a single alignment aid.

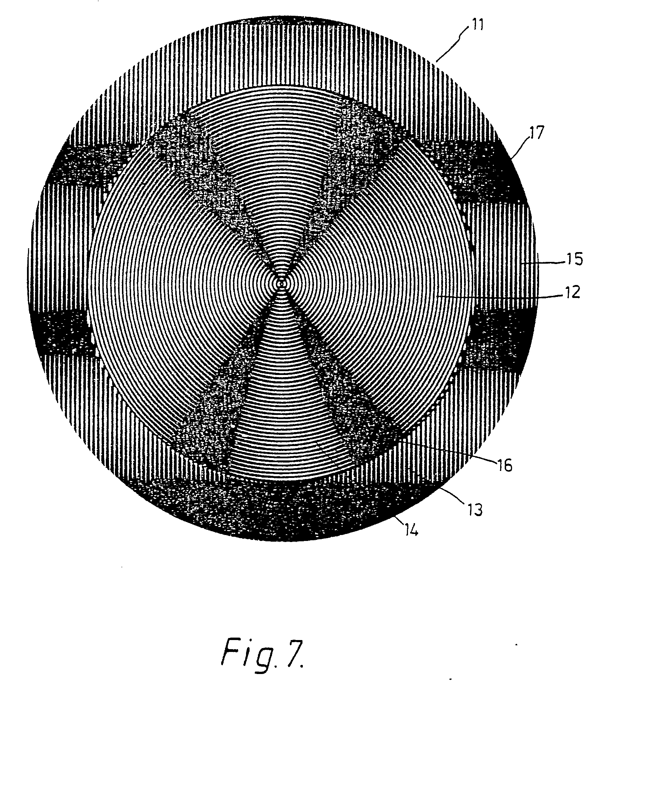

Figure 7 shows an alignment and 11 with fringes 16 and 17 in both portions 12 and 13 due to misalignment both translationally and angularly. An operator in aligning two transparencies will move one transparency relative to the other so as to eliminate the fringes 16, 17 in both portions of the alignment aid. The requirement for microscopically viewing each alignment aid individually as in prior art devices is thereby eliminated.

An important use for an alignment aid according to the present invention is in the photographic printing process. In order to carry out colour balancing and adjustment a single photograph is split up into several monochrome transparencies typically one black and one for each primary colour. An alignment aid applied to the original photograph is reproduced on each monochrome transparency. Colour correction is then carried out on each separate transparency before all the transparencies are superimposed to produce the required master negative. Use of the alignment aids reproduced on each transparency enables quick and accurate absolute alignment of the individual transparencies, in order to produce a colour corrected reproduction of the original.

In some colour printing processes such as offset lithography, only one colour of ink can be deposited on to the paper at any one time. Therefore the original colour photograph or other representation must be split into several monochrome transparencies to enable individual printing plates to be made for each required colour. An alignment aid of the kind provided by the present invention, incorporated on to the border of the colour photograph, will ensure that each monochrome transparency has an alignment aid thereon. By transferring the alignment aid from one transparency on to each of the plates to be used (typically by photochemical etching), subsequent monochrome transparencies can be accurately aligned each with its respective printing plate. This will help to ensure that each printing plate deposits its coloured ink in the correct position relative to those already on the paper.

A further use for the alignment aid is in the manufacture of double sided printed circuit boards. Typically the conductive pattern on a printed circuit board is formed by transferring the pattern from a 'master' transparency to the board by photochemical etching. It is common practice to transfer patterns to both sides of the board, either for the purpose of mounting the maximum amount of electronic circuitry on the board or for the purpose of shielding the circuit from electrical interference. When patterns are applied to both sides of the board, they must be aligned to ensure that components mounted on one side of the board remain electrically isolated from components or condutive tracks on the other side.

Since the two master transparencies are separated by the board, alignment cannot be made by visually inspecting the registration of the two patterns. For this reason, it is necessary to provide some alternative means for achieving accurate superposition of the transparencies on opposite sides of the board. This can very conveniently be done by the provision of an alignment aid according to the invention near the perimeter of each master transparency. The board is then placed between the two master transparencies so that the alignment aids fall outside its boundary. The transparencies can thus be accurately registered in absolute alignment by direct visual inspection and adjustment, prior to transfer of the conductive pattern from the transparencies to the board.

## Claims

1. An article having an alignment aid thereon characterised by comprising a single region of markings in the form of closely spaced lines, the arrangement of lines within the region being such that on superimposition of such an alignment aid on a transparency over such an alignment aid on another article Moire fringes (2, 3) are formed by interaction of the superimposed markings of the respective single regions unless the alignment aids are aligned in both translational and angular senses, the closely spaced lines being in the form of at least one spiral (1).

2. An article according to claim 1 characterised in that the closely spaced lines are in the form of at least two concentric spirals (1).

3. An article having an alignment aid (11) thereon characterised by comprising a single region of markings in the form of closely spaced lines, the arrangement of lines within the region being such that on superimposition of such an alignment aid on a transparent over such an alignment air on another article Moire fringes (16, 17) are formed by interaction of the superimposed markings of the respective single regions unless the alignment aids are aligned in both translational and angular senses, wherein the arrangement of closely spaced lines comprises a zone (13) of straight parallel lines (15) and a zone (12) wherein the closely spaced lines are in the form of concentric circles (14).

4. An article according to claim 3 characterised in that the zone (13) of parallel lines (15) surrounds the zone (12) of concentric circles (14).

5. An article having an alignment aid thereon characterised by comprising a single region of markings in the form of closely spaced lines, the arrangement of lines within the region being such that on superimposition of such an alignment aid on a transparency over such an alignment aid on another article Moire fringes are formed by interaction of the superimposed markings of the respective single regions unless the alignment aids are aligned in both translation and angular senses, wherein the closely spaced lines are in the form of concentric ellipses having a common major axis.

6. An article according to any one of claims 1 to 5 characterised in that the adjacent lines of the markings are equi-spaced one from another.

7. An article according to any one preceding claim, the article being a photographic transparency.

8. An article according to any one preceding claim, the article being a printing plate.

9. A process for reproducing an image of an original representation characterised by comprising the steps of

applying to the original representation an alignment aid so as to create an article in accordance with any one preceding claim,

preparing a plurality of transparencies each representing a component of the original representation and each including a reproduction of the alignment aid,

and reproducing an image of each transparency in turn, successive images being superimposed in accurate alignment by use of the reproductions of the alignment aid.

10. A process according to claim 9 characterised in that the original representation is a colour photograph, each transparency represents a monochrome component thereof, and each transparency is subjected to colour correction prior to reproduction of an image thereof.

11. A process according to claim 9 characterised in that the original representation is in colour, each transparency represents a monochrome component thereof, an image of each transparency including the alignment aid is reproduced on a respective printing plate, and a monochrome image of each transparency is printed from its respective plate, successive images being superimposed in accurate alignment by use of reproductions of the alignment aid.

12. A process for the production of a double sided printed circuit board, comprising the steps of

preparing two master transparencies each representing the conductive pattern to be applied to one side of the board,

characterised by including on each master transparency an alignment aid so as to create an article in accordance with any one of claims 1 to 8, 10 or 11, the alignment aid being so positioned as to fall outside the boundary of the board when aligned therewith,

superimposing and aligning the two master transparencies on opposite sides of the board by use of superimposed alignment aids, and

transferring the pattern of the two master transparencies to the opposite sides of the board.

**Patentansprüche**

1. Einrichtung mit einer darauf befindlichen Ausrichtungshilfe, gekennzeichnet durch einen einzelnen Markierungsbereich von der Form dicht beieinanderliegender Linien, wobei die Linien in dem Bereich so angeordnet sind, daß bei Überlagerung einer solchen auf einem Transparentbild angebrachten Ausrichtungshilfe mit einer auf einer weiteren Einrichtung befindlichen Ausrichtungshilfe aufgrund der Wechselwirkung der überlagerten Markierungen der Wechselwirkung der überlagerten Markierungen der entsprechenden einzelnen Bereiche Moiréstreifen (2, 3) gebildet werden, wenn die Ausrichtungshilfen nicht in Translations- und in Drehrichtung ausgerichtet sind, und wobei die dicht beieinanderliegenden Linien von der Form wenigstens einer Spirale (1) sind.

2. Einrichtung gemäß Anspruch 1, dadurch gekennzeichnet, daß die dicht beieinanderliegenden Linien von der Form wenigstens zweier konzentrischer Spiralen (1) sind.

3. Einrichtung mit einer darauf befindlichen Ausrichtungshilfe (11), gekennzeichnet durch einen einzelnen Markierungsbereich von der Form dicht beieinanderliegender Linen, wobei die Linien in dem Bereich so angeordnet sind, daß be Überlagerung einer solchen auf einem Transparentbild angebrachten Ausrichtungshilfe mit einer auf einer weiteren Einrichtung befindlichen Ausrichtungshilfe aufgrund der Wechselwirkung der überlagerten Markierung der entsprechenden einzelnen Bereiche Moiréstreifen (16, 17) gebildet werden, wenn die Ausrichtungshilfen nicht in Translations- und in Drehrichtung ausgerichtet sind, und wobei die Anordnung der dicht beieinanderliegenden Linien eine Zone (13) von geraden, parallelen Linien (15) und eine Zone (12), in der die dicht beieinanderliegenden Linien von der Form konzentrischer Kreise (14) sind, aufweist.

4. Einrichtung gemäß Anspruch 3, dadurch gekennzeichnet, daß die Zone (13) von parallelen Linien (15) die Zone (12) von konzentrischen Kreisen (14) umgibt.

5. Einrichtung mit einer darauf befindlichen Ausrichtungshilfe, gekennzeichnet durch einen einzelnen Markierungsbereich von der Form dicht beieinanderliegender Linien, wobei die Linien in dem Bereich so angeordnet sind, daß bei Überlagerung einer solchen auf einem Transparentbild angebrachten Ausrichtungshilfe mit einer auf einer weiteren Einrichtung befindlichen Ausrichtungshilfe aufgrund der Wechselwirkung der überlagerten Markierungen der entsprechenden einzelnen Bereiche Moiréstreifen gebildet werden, wenn die Ausrichtungshilfen nicht in Translations- und in Drehrichtung ausgerichtet sind, und wobei die dicht beieinanderliegenden Linien von der Form konzentrischer Ellipsen mit einer gemeinsamen Hauptachse sind.

6. Einrichtung gemäß einem der Ansprüche 1 bis 5, dadurch gekennzeichnet, daß die benachbarten Linien der Markierungen jeweils im gleichen Abstand angeordnet sind.

7. Einrichtung gemäß einem der voranstehenden Ansprüche, wobei die Einrichtung ein fotografisches Transparentbild ist.

8. Einrichtung gemäß einem der voranstehenden Ansprüche, wobei die Einrichtung eine Druckplatte ist.

9. Verfahren für die Bildreproduktion einer Vorlage, gekennzeichnet durch die Schritte

des Anwendens einer Ausrichtungshilfe auf die Vorlage, um eine Einrichtungen gemäß einem der voranstehenden Ansprüche zu erzeugen,

des Herstellens einer Mehrzahl von Transparentbildern, von denen jedes eine Komponente der Vorlage darstellt und von denen jedes eine Reproduktion der Ausrichtungshilfe aufweist, und des Reproduzierens eines Bildes nacheinander aus jedem Transparentbild, indem die aufeinanderfolgenden Bilder unter Verwendung der Reproduktionen der Ausrichtungshilfe genau ausgerichtet überlagert werden.

10. Verfahren gemäß Anspruch 9, dadurch gekennzeichnet, daß die Vorlage ein Farbfoto ist, daß jedes Transparentbild hiervon eine monochromatische Komponente darstellt und daß jedes Transparentbild vor der Bildreproduktion einer Farbkorrktur unterworfen wird.

11. Verfahren gemäß Anspruch 9, dadurch gekennzeichnet, daß die Vorlage farbig ist, daß jedes Transparentbild hiervon eine monochromatische Komponente darstellt, daß das Bild eines jeden die Ausrichtungshilfe enthaltenden Transparentbildes auf einer entsprechenden Druckplatte reproduziert wird und daß das monochromatische Bild eines jeden Transparentbildes von seiner entsprechenden Platte abgezogen wird, wobei die aufeinanderfolgenden Bilder unter Verwendung der Reproduktionen der Ausrichtungshilfe genau ausgerichtet überlagert werden.

12. Verfahren für die Herstellung einer zweiseitigen Platine mit den Schritten

des Herstellens zweier Haupt-Transparentbilder, von denen jedes die auf eine Seite der Platte aufzubringende Leitungsstruktur darstellt, dadurch gekennzeichnet, daß auf jedem Haupt-Transparentbild eine Ausrichtungshilfe vorgesehen ist, um eine Einrichtung gemäß einem der Ansprüche 1 bis 8, 10 oder 11 zu erzeugen, wobei die Ausrichtungshilfe so angeordnet ist, daß sie außerhalb des Randes der Platte liegt, wenn sie mit dieser ausgerichtet wird,

des Überlagerns und Ausrichtens zweiter Haupt-Transparentbilder auf gegenüberliegenden Seiten der Platte, indem die überlagerten Ausrichtungshilfen verwendet werden, und

des Übertragens der Struktur der zwei Haupt-Transparentbilder auf die gegenüberliegenden Seiten der Platte.

**Revendications**

1. Article ayant un dispositif d'assistance à l'alignement placé sur lui, caractérisé en ce qu'il comprend une région unique de marquage sous forme de lignes très rapprochées, la disposition des lignes dans la région étant telle que, après superposition d'un tel dispositif d'assistance à l'alignement porté par une diapositive à un tel dispositif d'assistance à l'alignement porté par un autre article, des franges de moiré (2, 3) se forment par interaction des marquages superposés des régions uniques respectives, à moins que les dispositifs d'assistance à l'alignement ne soient alignés à la fois en translation et angulairement, les lignes très rapprochées étant sous forme d'au moins une spirale (1).

2. Article selon la revendication 1, caractérisé en ce que les lignes très rapprochées sont sous forme d'au moins deux spirales concentriques (1).

3. Article muni d'un dispositif d'assistance à l'alignement (11) placé sur lui, caractérisé en ce

qu'il comprend une région unique de marquage sous forme de lignes très rapprochées, la disposition des lignes dans ladite région étant telle que, après superposition d'un tel dispositif d'assistance à l'alignement porté par une diapositive à un dispositif d'assistance à l'alignement porté par un autre article, des franges de moiré (16, 17) se forment par interaction des marquages superposés des régions uniques respectives à moins que les dispositif d'assistance à l'alignement ne soient alignés à la fois en translation et angulairement, la disposition des lignes très rapprochées comprenant une zone (13) de droites parallèles (15) et une zone (12) dans laquelle les lignes très rapprochées sont sous forme de cercles concentriques (14).

4. Article selon la revendication 3, caractérisé en ce que la zone (13) des droites parallèles (15) entoure la zone (12) des cercles concentriques (14).

5. Article ayant un dispositif d'assistance à l'alignement placé sur lui, caractérisé en ce qu'il comprend une région unique de marquage sous forme de lignes très rapprochées, la disposition des lignes dans ladite région étant telle que, après superposition d'un tel dispositif d'assistance à l'alignement porté par une diapositive à un dispositif d'assistance à l'alignement porté par un autre article, des franges de moiré soient formées par interaction des marquages superposés des régions uniques respectives, à moins que les dispositifs d'assistance à l'alignement ne soient alignés à la fois en translation et angulairement, les lignes très rapprochées étant sous forme d'ellipses concentriques ayant un grand axe commun.

6. Article selon l'une quelconque des revendications 1 à 4, caractérisé en ce que les lignes adjacentes des marquages sont équidistantes les unes des autres.

7. Article selon l'une quelconque des revendications précédentes, sous forme d'une diapositive photographique.

8. Article selon l'une quelconque des revendications précédentes, sous forme d'un cliché d'impression.

9. Procédé de reproduction d'une image d'une représentation orginale, caractérisé en ce qu'elle comprend les étapes suivantes:

l'application, à la représentation originale, d'un dispositif d'assistance à l'alignement afin qu'un article selon l'une quelconque des revendications précédentes soit créé,

la préparation de plusieurs diapositives représentant chacune une composante de la représentation originale et contenant chacune une reproduction du dispositif d'assistance à l'alignement, et

la reproduction d'une image de chaque diapositive à son tour, les images successives étant superposées avec un alignement précis par utilisation des reproductions du dispositif d'assistance à l'alignement.

10. Procédé selon la revendication 9, caractérisé en ce que la représentation originale est une photographie en couleurs, chaque diapositive représentant une composante monochrome de la photographie et chaque diapositive étant soumise à une correction de couleur avant la reproduction d'une image de celle-ci.

11. Procédé selon la revendication 9, caractérisé en ce que la représentation originale est en couleurs, chaque diapositive représente une composante monochrome de la représentation, une image de chaque diapositive comprenant le dispositif d'assistance à l'alignement est reproduite sur un cliché respectif, et une image monochrome de chaque diapositive est imprimée à partir du cliché respectif, les images successives étant superposées en étant alignées avec précision à l'aide des reproductions du dispositif d'assistance à l'alignement.

12. Procédé de production d'une carte de circuit imprimé ayant deux faces imprimées, comprenant les étapes suivantes:

la préparation de deux diapositives maîtresses représentant chacune le dessin conducteur qui doit être appliqué sur une face de la carte, caractérisé par l'incorporation, sur chaque diapositive maîtresse, d'un dispositif d'assistance à l'alignement afin qu'un article selon l'une quelconque des revendications 1 à 8, 10 ou 11 soit créé, le dispositif d'assistance à l'alignement étant disposé afin qu'il se trouve en dehors de la limite de la carte lorsqu'il est aligné sur celle-ci,

la superposition et l'alignement des deux diapositives maîtresses sur les faces opposées de la carte à l'aide des dispositifs superposés d'assistance à l'alignement, et

le report du dessin des deux diapositives maîtresses sur les faces opposées de la carte.

Fig.1.

Fig.2.

Fig.3.

Fig.4.

Fig.5.

Fig. 6.

Fig. 7.